(19) Europäisches Patentamt
European Patent Office
Office européen des brevets

(11) **EP 3 719 996 A1**

(12) **EUROPÄISCHE PATENTANMELDUNG**

(43) Veröffentlichungstag:
**07.10.2020 Patentblatt 2020/41**

(51) Int Cl.:
**H03K 17/082** (2006.01)  **H03K 17/16** (2006.01)
**B60L 15/08** (2006.01)  **H02H 3/087** (2006.01)

(21) Anmeldenummer: **19167525.5**

(22) Anmeldetag: **05.04.2019**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(71) Anmelder: **Lisa Dräxlmaier GmbH
84137 Vilsbiburg (DE)**

(72) Erfinder:
• **Hofinger, Stefan Johann
84427 Sankt Wolfgang (DE)**
• **Immel, Alexander
84030 Ergolding (DE)**
• **Schafferhans, Stephan
81476 München (DE)**
• **Pfeiffer, Michael
80997 München (DE)**

(54) **TRENNVORRICHTUNG, VERFAHREN UND HERSTELLVERFAHREN**

(57)  Die vorliegende Erfindung offenbart eine Trennvorrichtung (100, 200) für einen elektrischen Lastpfad (143) zur Versorgung elektrischer Lasten (144), aufweisend einen Leistungseingang (101, 201), einen Leistungsausgang (102, 202), ein halbleiterbasiertes Schaltelement (103, 203), wobei der Lastpfad des halbleiterbasierten Schaltelements (103, 203) elektrisch zwischen dem Leistungseingang (101, 201) und dem Leistungsausgang (102, 202) angeordnet ist, und eine Steuereinrichtung (105, 205), welche einen Steuerausgang (106) aufweist, der mit einem Steuereingang (104) des halbleiterbasierten Schaltelements (103, 203) gekoppelt ist, wobei die Steuereinrichtung (105, 205) ausgebildet ist, zum Schließen des halbleiterbasierten Schaltelements (103, 203) bis zum Erreichen einer vorgegebenen Betriebsspannung an dem Leistungsausgang (102, 202) das halbleiterbasierte Schaltelement (103, 203) in einem Pulsbetrieb zu schließen und zu öffnen. Ferner offenbart die vorliegende Erfindung ein entsprechendes Verfahren und ein Herstellverfahren.

Fig. 1

## Beschreibung

### Technisches Gebiet

Die vorliegende Erfindung betrifft eine Trennvorrichtung für einen elektrischen Lastpfad zur Versorgung elektrischer Lasten. Ferner betrifft die vorliegende Erfindung ein entsprechendes Verfahren und ein Herstellverfahren für eine Trennvorrichtung.

### Stand der Technik

Die vorliegende Erfindung bezieht sich auf die zuverlässige Trennung von elektrischen Lasten, insbesondere im Bezug elektrische Lasten, die in einem Fahrzeug auftreten.

Bei modernen Fahrzeugen wird versucht, den Verbrauch von fossilen Brennstoffen und damit den Ausstoß schädlicher Gase zu reduzieren. Eine Möglichkeit dazu besteht darin, den Verbrennungsmotor in dem Fahrzeug durch einen Elektromotor zu unterstützen bzw. den Verbrennungsmotor durch einen Elektromotor zu ersetzen.

In solchen Fahrzeugen müssen folglich stabile Versorgungsnetze für Hochleistungselektromotoren installiert werden. In solchen Versorgungsnetzen können Nennspannungen von mehreren hundert Volt vorgesehen sein und die Elektromotoren können Leistungen von mehreren hundert Kilowatt aufweisen.

Bordnetze für Elektro- oder Hybridfahrzeuge weisen häufig einen sogenannten Zwischenkreis, insbesondere für den Hochvoltbereich, auf. In einem solchen Zwischenkreis werden üblicherweise elektrische Puffer in Form von Kapazitäten bzw. Kondensatoren eingesetzt. Diese Puffer dienen vor allem zur Bereitstellung einer definierten Ausgangsspannung, also einer Spannung mit geringer Welligkeit. Aufgrund von Sicherheitsüberlegungen werden die Zwischenkreise beim Abstellen des Fahrzeugs physisch von der Energiequelle, beispielsweise einer Fahrzeugbatterie, getrennt. Für diese physische Trennung werden üblicherweise mechanische Schütze eingesetzt. Um den Einschaltstrom im Bordnetz zu begrenzen, wird in solchen Bordnetzen zusätzlich zu dem jeweiligen Hauptschütz noch ein Vorladeschütz mit einem entsprechenden Serienwiderstand zur Strombegrenzung benötigt. Die Anordnung im Bordnetz und die koordinierte Nutzung des Hauptschütz und des Vorladeschütz erhöht jedoch die Komplexität des Bordnetzes.

### Beschreibung der Erfindung

Eine Aufgabe der Erfindung ist es daher, unter Einsatz konstruktiv möglichst einfacher Mittel ein Zuschalten eines Zwischenkreises zu ermöglichen.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben. Insbesondere können die unabhängigen Ansprüche einer Anspruchskategorie auch analog zu den abhängigen Ansprüchen einer anderen Anspruchskategorie weitergebildet sein.

Eine erfindungsgemäße Trennvorrichtung für einen elektrischen Lastpfad zur Versorgung elektrischer Lasten weist auf einen Leistungseingang, einen Leistungsausgang, ein halbleiterbasiertes Schaltelement, wobei der Lastpfad des halbleiterbasierten Schaltelements elektrisch zwischen dem Leistungseingang und dem Leistungsausgang angeordnet ist, und eine Steuereinrichtung, welche einen Steuerausgang aufweist, der mit einem Steuereingang des halbleiterbasierten Schaltelements gekoppelt ist, wobei die Steuereinrichtung ausgebildet ist, zum Schließen des halbleiterbasierten Schaltelements bis zum Erreichen einer vorgegebenen Betriebsspannung an dem Leistungsausgang das halbleiterbasierte Schaltelement in einem Pulsbetrieb zu schließen und zu öffnen.

Ein Verfahren zum Betreiben einer Trennvorrichtung für einen elektrischen Lastpfad zur Versorgung elektrischer Lasten weist die folgenden Schritte auf: Öffnen und Schließen eines halbleiterbasierten Schaltelements, dessen Lastpfad elektrisch zwischen einem Leistungseingang und einem Leistungsausgang der Trennvorrichtung angeordnet ist, bis zum Erreichen einer vorgegebenen Betriebsspannung an dem Leistungsausgang in einem Pulsbetrieb, und Schließen des halbleiterbasierten Schaltelements nach Erreichen einer vorgegebenen Betriebsspannung an dem Leistungsausgang.

Ein Herstellverfahren für eine Trennvorrichtung für einen elektrischen Lastpfad zur Versorgung elektrischer Lasten weist die folgenden Schritte auf: Bereitstellen eines Leistungseingangs, Bereitstellen eines Leistungsausgangs, Anordnen eines Lastpfads eines halbleiterbasierten Schaltelements elektrisch zwischen dem Leistungseingang und dem Leistungsausgang, Bereitstellen einer Steuereinrichtung, welche ausgebildet ist, zum Schließen des halbleiterbasierten Schaltelements bis zum Erreichen einer vorgegebenen Betriebsspannung an dem Leistungsausgang das halbleiterbasierte Schaltelement in einem Pulsbetrieb zu schließen und zu öffnen, und Verbinden eines Steuerausgangs der Steuereinrichtung mit einem Steuereingang des halbleiterbasierten Schaltelements.

Die vorliegende Erfindung basiert auf der erstaunlichen Erkenntnis, dass bisher genutzte mechanische Schütze durch halbleiterbasierte Schaltelemente ersetzt werden können. Es hat sich darüber hinaus als sehr vorteilhaft erwiesen, dass halbleiterbasierte Schaltelemente eine größere Flexibilität bezüglich der Schließ- und Öffnungsvorgänge im Vergleich zu mechanischen Schützen aufweisen und damit eine gezielte Begrenzung der Einschaltströme erlauben.

Wie oben bereits erläutert, ist es nötig, in einem elektrischen Lastpfad zur Versorgung elektrischer Lasten mit mindestens einem Zwischenkreis diesen Vorzuladen, um das Auftreten hoher Einschaltströme zu vermeiden. Bei der Verwendung eines halbleiterbasierten Schaltelements kann weiterhin in üblicher Art und Weise ein paralleler Schalter mit Serienwiderstand als Vorladeschütz zum Vorladen des Zwischenkreises zusätzlich vorgesehen sein.

Die vorliegende Erfindung stellt aber die einzigartige Möglichkeit bereit, den Zwischenkreis in einem solchen elektrischen Lastpfad zur Versorgung elektrischer Lasten vorzuladen, ohne dass zusätzlich zu dem Hauptschütz weitere Elemente bereitgestellt werden müssen, wie es im Stand der Technik üblich ist.

Dazu sieht die vorliegende Erfindung die Trennvorrichtung vor, in der zwischen dem Leistungseingang und dem Leistungsausgang ein halbleiterbasiertes Schaltelement angeordnet ist. Das halbleiterbasierte Schaltelement kann beispielsweise als ein Solid-State-Relais - abgekürzt SSR - oder dergleichen ausgebildet sein. Solche halbleiterbasierten Schaltelemente können im Gegensatz zu üblichen elektromechanischen Schaltern ohne Einschränkungen unter Last schalten.

Die vorliegende Erfindung nutzt diese Eigenschaft der halbleiterbasierten Schaltelemente und sieht vor, dass die halbleiterbasierten Schaltelemente beim Zuschalten eines Zwischenkreises bzw. beim Schließen des jeweiligen halbleiterbasierten Schaltelements in einem Pulsbetrieb betrieben werden. Der Pulsbetrieb kann dabei so lange aufrechterhalten werden, bis die Spannung an dem Leistungsausgang eine vorgegebene Betriebsspannung erreicht. Das Schließen des halbleiterbasierten Schaltelements erfolgt also nicht einmalig. Vielmehr ist unter dem Begriff "Schließen" hier ein Prozess zu verstehen, der aus dem gepulsten Betrieb des halbleiterbasierten Schaltelements bis zum Erreichen der Betriebsspannung am Leistungsausgang besteht.

Die Trennvorrichtung gemäß der vorliegenden Erfindung kann folglich in dem Lastpfad eines Versorgungssystems in einem Fahrzeug mit einem teilweisen oder ausschließlichen Elektroantrieb eingesetzt werden. Die Trennvorrichtung kann dabei zwischen der Batterie und dem Zwischenkreis, insbesondere ein Hochvolt-Zwischenkreis, eingesetzt werden. Wird ein elektrischer Lastpfad des Fahrzeugs in Betrieb genommen, muss der zugeordnete Zwischenkreis zugeschaltet werden, insbesondere falls der Lastpfad unter Hochvolt betrieben wird. Würde ein mechanischer Schalter in dieser Situation direkt geschlossen werden, würde der Einschaltstrom sehr hoch sein und könnte Komponenten des Bordnetzes schädigen.

Die Steuereinrichtung wird zur Vermeidung eines zu hohen Einschaltstroms das halbleiterbasierte Schaltelement für einen gewissen Zeitraum in einem Pulsbetrieb betreiben.

In Sinne der Erfindung bedeutet Pulsbetrieb, dass das halbleiterbasierte Schaltelement für einen gewissen Zeitraum mit definierten Schaltzeiten zyklisch ein- und ausgeschaltet wird. Die Schaltzeiten sollten derart gewählt werden, dass der Einschaltstrom höchstens auf das maximal zulässige Niveau für das jeweilige Versorgungssystem begrenzt ist. Dabei kann in jedem Zyklus die Dauer des Einschaltens, $T_{on}$, von der Dauer des Ausschaltens, $T_{off}$, abweichen. Insbesondere kann die Dauer des Ausschaltens $T_{off}$ länger sein, als die Dauer des Einschaltens $T_{on}$, dies erlaubt in jedem Zyklus des Pulsbetriebs den Abbau der elektrischen Energie, welche in den in dem Bordnetz, insbesondere im Zwischenkreis, vorhandenen Induktivitäten gespeichert ist und die zu Spannungsspitzen führt.

Ist der Zwischenkreis auf die vorgegebene Betriebsspannung aufgeladen, kann das halbleiterbasierte Schaltelement geschlossen und der Pulsbetrieb damit beendet werden.

Mit Hilfe der vorliegenden Erfindung kann die Funktion des Vorladens eines Hochvolt-Zwischenkreises in das halbleiterbasierte Schaltelement integriert werden. Die vorliegende Erfindung erlaubt folglich einen deutlich vereinfachten Aufbau des Trennelements und damit eine Reduzierung der Komplexität des Bordnetzes im Vergleich zu herkömmlichen Bordnetzen. Die Verwendung eines erfindungsgemäßen Trennelements erlaubt damit einen einfacheren Aufbau des Bordnetzes, was zu einer verringerten Fehlerrate während des Betriebes des Lastpfads und einem reduzierten Bauraumbedarf des Bordnetzes führt.

Weitere Ausführungsformen und Weiterbildungen ergeben sich aus den Unteransprüchen sowie aus der Beschreibung unter Bezugnahme auf die Figuren.

In einer Ausführungsform kann die Steuereinrichtung ausgebildet sein, im Pulsbetrieb das halbleiterbasierte Schaltelement zyklisch für einen ersten vorgegebenen Zeitraum zu schließen und für einen zweiten vorgegebenen Zeitraum zu öffnen.

Die Steuereinrichtung steuert das halbleiterbasierte Schaltelement in dieser Ausführung mit festen, vorgegebenen Pulsdauern während des Pulsbetriebes für das Schließen des halbleiterbasierten Schaltelements.

Die Pulsdauer wird im Wesentlichen von der Eingangsspannung, den in dem Bordnetz vorhandenen Induktivitäten und dem maximal erlaubten Strom bestimmt. Insbesondere bestimmt die maximale Pulsdauer der erste Puls, da in diesem Moment die Zwischenkreisspannung $U_{zk}$ gleich null ist und somit die zeitliche Ableitung des Stromes $dI/dt$ am größten ist. Die Pulsdauer wird während des gesamten Ladevorgangs nicht verändert.

Bei dieser Ausführung sollte die Systeminduktivität bekannt sein bzw. mit einer angenommenen Induktivität gerechnet werden. Es versteht sich, dass bei der Annahme einer Induktivität ein Sicherheitsaufschlag einbezogen werden kann. Die Dauer berechnet sich in guter Näherung dann zu T = (L*$I_{max}$)/$U_{bat}$, wobei L die im System vorhandene Induktivität darstellt, $I_{max}$ den maximal zulässigen Strom kennzeichnet und $U_{bat}$ die Batteriespannung darstellt. Die momentane Zwischenkreisspannung $U_{zk}$ geht bei diesen Betrachtungen nicht ein, da die Zwischenkreisspannung $U_{zk}$ zu Beginn des Pulsbetriebs gleich null ist.

Wird eine feste Pulsdauer vorgesehen, kann die Steuerung des halbleiterbasierten Schaltelements in der Steuereinrichtung sehr einfach implementiert werden.

In einer weiteren Ausführungsform kann die Trennvorrichtung einen Stromsensor aufweisen, welcher ausgebildet ist, den Strom im Lastpfad des halbleiterbasierten Schaltelements zu erfassen. Die Steuereinrichtung kann entsprechend ausgebildet sein, im Pulsbetrieb das halbleiterbasierte Schaltelement zyklisch basierend auf dem durch den Stromsensor gemessenen Strom zu öffnen und zu schließen.

Die Recheneinrichtung ist in dieser Ausführung ausgebildet, die Zeitdauer für das Einschalten des halbleiterbasierten Schaltelements im Pulsbetrieb dynamisch anzupassen. Dabei dient der gemessene Strom als Führungsgröße. Der Stromsensor kann beispielsweise einen Shunt-Widerstand mit einer entsprechenden Spannungsmessung aufweisen. Zusätzlich oder alternativ kann die Strommessung über die Messung des Widerstandes des halbleiterbasierten Schaltelements, einem Stromsensor nach dem Hallprinzip oder einem anderen Prinzip zur Strommessung arbeiten.

Werden die Pulsdauern im Pulsbetrieb dynamisch an den fließenden Strom angepasst, kann der Aufladeprozess für den Zwischenkreis optimiert werden. Mit steigender Spannung am Leistungsausgang, also steigender Zwischenkreisspannung $U_{zk}$, sinkt die Steilheit des Stromgradienten dI/dt beim Schließen des halbleiterbasierten Schaltelements. Das halbleiterbasierte Schaltelement kann folglich länger geschlossen bleiben, bis ein vorgegebener Strom erreicht wird.

Da wie oben bereits erläutert bei festen Pulsdauern mit dem kürzesten Puls beim ersten Einschalten gerechnet werden muss (Zwischenkreisspannung $U_{zk}$ gleich null), kann durch die dynamische Anpassung der Pulsdauern der Zwischenkreis schneller geladen werden.

In einer weiteren Ausführungsform kann die Steuereinrichtung ausgebildet sein, das halbleiterbasierte Schaltelement zu öffnen, wenn der gemessene Strom einen vorgegebenen Maximalwert erreicht und das halbleiterbasierte Schaltelement zu schließen, wenn der gemessene Strom einen vorgegebenen Minimalwert erreicht, bzw. diesen unterschreitet.

Der vorgegebene Maximalwert kann insbesondere derjenige Stromwert sein, der in dem Lastpfad als "sicher" betrachtet wird. Der Maximalwert wird folglich derart definiert, dass bei Erreichen des Maximalwerts keinerlei Beeinträchtigung bzw. Schädigung von Elementen in der Trennvorrichtung bzw. dem Lastpfad auftritt. Es versteht sich, dass der Maximalwert deutlich über dem Nenn- bzw. Betriebsstrom in dem Lastpfad liegen kann. Der Minimalwert des Stromwerts muss kleiner als der Maximalwert sein und kann unter dieser Einschränkung jeden Wert annehmen, der größer oder gleich Null ist.

Wird der Maximalwert festgelegt und der Minimalwert mit Null vorgegeben, kann die Dauer für einen Einschaltimpuls berechnet werden.

Für die Dauer des Einschaltimpulses gilt damit in guter Näherung folgende Gleichung:

$$T = (L * I_{max}) / (U_{bat} - U_{zk})$$

wobei L die im System vorhandene Induktivität darstellt, $I_{max}$ den maximal zulässigen Strom kennzeichnet, $U_{bat}$ die Batteriespannung bzw. Eingangsspannung am Leistungseingang, und $U_{zk}$ die Zwischenkreisspannung darstellt. In der vorangegangenen Gleichung werden ohmsche Anteile im Lastkreis vernachlässigt und angenommen das während eines Pulsvorgang die Zwischenkreisspannung $U_{zk}$ konstant ist

Die stromgeführte Pulsdauer ermöglicht es, den Zwischenkreis schneller zu laden als mit konstanten Pulsen, da die Pulsdauer der Zwischenkreisspannung nachgeführt wird. Ein weiterer Vorteil ist, dass durch die Strommessung die Systemparameter $U_{bat}$ und L, sowie die Kapazität $C_{zk}$ im Zwischenkreis, implizit in den maximalen Strom bzw. in den Stromanstieg di/dt miteingehen und sich somit der Pulsbetrieb immer an diese anpasst.

In einer weiteren Ausführungsform kann die Steuereinrichtung ausgebildet sein, das halbleiterbasierte Schaltelement zu schließen, wenn der gemessene Stromwert einen konstanten Wert unterhalb des vorgegebenen Maximalwerts einnimmt.

Der stromgeführte Pulsbetrieb ist sehr sicher, da der maximal zulässige Strom auch im Fehlerfall nicht überschritten wird, beispielsweise bei einem Kurzschluss im Zwischenkreis.

Ist der Zwischenkreis geladen, wird der maximal zulässige Strom nicht mehr überschritten und das halbleiterbasierte Schaltelement kann durchgeschaltet bleiben. Die Steuereinrichtung kann also dynamisch anhand der Strommessung erkennen, wann der Zwischenkreis auf die Eingangsspannung aufgeladen ist.

In noch einer weiteren Ausführungsform kann die Steuereinrichtung ausgebildet sein, nach dem Beenden des Pulsbetriebs das halbleiterbasierte Schaltelement zu öffnen, wenn der von dem Stromsensor gemessene Strom einen vorgegebenen Grenzwert überschreitet.

Der vorgegebene Grenzwert kann insbesondere dem Auslösestrom eines üblicherweise in der Trennvorrichtung bzw. dem Lastpfad eingesetzten Sicherungselements entsprechen. Es versteht sich, dass der Grenzwert größer sein kann, als der oben genannte Maximalwert.

Wird das halbleiterbasierte Schaltelement bei Erreichen dieses Stroms in dem Lastpfad geöffnet, wird der Stromfluss genauso unterbrochen, als hätte ein solches Sicherungselement ausgelöst. Folglich kann die Trennvorrichtung die Funktion eines solchen Sicherungselements übernehmen. In dem Trennelement bzw. dem Lastpfad muss folglich kein separates Sicherungselement mehr vorgesehen werden, wie es sonst im Stand der Technik üblich ist.

Es versteht sich, dass zur Nutzung der Trennvorrichtung bzw. des halbleiterbasierten Schaltelements als Ersatz für eine Sicherung die Trennvorrichtung entsprechend ausgelegt werden kann. Insbesondere können gesetzliche oder regulatorische Anforderungen an ein Sicherungselement bestehen, die die Auslegung der Trennvorrichtung gemäß einem vorgegebenen Sicherheitsniveau (Automotive Safety Integrity Level - kurz ASIL) erfordern.

Es versteht sich daher auch, dass die Energieversorgung der Steuereinrichtung, die Steuereinrichtung selbst, der Stromsensor und weitere Elemente in der Trennvorrichtung redundant ausgelegt werden können. Ferner kann eine entsprechende Überwachung der jeweiligen Elemente innerhalb des Lastpfads vorgesehen werden.

**Kurze Figurenbeschreibung**

Nachfolgend werden vorteilhafte Ausführungsbeispiele der Erfindung unter Bezugnahme auf die begleitenden Figuren erläutert. Es zeigen:

Figur 1   ein Blockschaltbild eines Ausführungsbeispiels eines elektrischen Versorgungssystems gemäß der vorliegenden Erfindung;

Figur 2   ein Blockschaltbild eines weiteren Ausführungsbeispiels einer Trennvorrichtung gemäß der vorliegenden Erfindung;

Figur 3   ein Ablaufdiagramm eines Ausführungsbeispiels eines Verfahrens gemäß der vorliegenden Erfindung;

Figur 4   ein Ablaufdiagramm eines Ausführungsbeispiels eines Herstellverfahrens gemäß der vorliegenden Erfindung;

Figur 5   ein Diagramm mit Spannungs- und Stromverlauf in einem Lastpfad mit einer Ausführungsform einer Trennvorrichtung gemäß der vorliegenden Erfindung; und

Figur 6   ein Diagramm mit Stromverläufen beim Pulsbetrieb von Ausführungsformen einer Trennvorrichtung gemäß der vorliegenden Erfindung.

Die Figuren sind lediglich schematische Darstellungen und dienen nur der Erläuterung der Erfindung. Gleiche oder gleichwirkende Elemente sind durchgängig mit den gleichen Bezugszeichen versehen.

**Detaillierte Beschreibung**

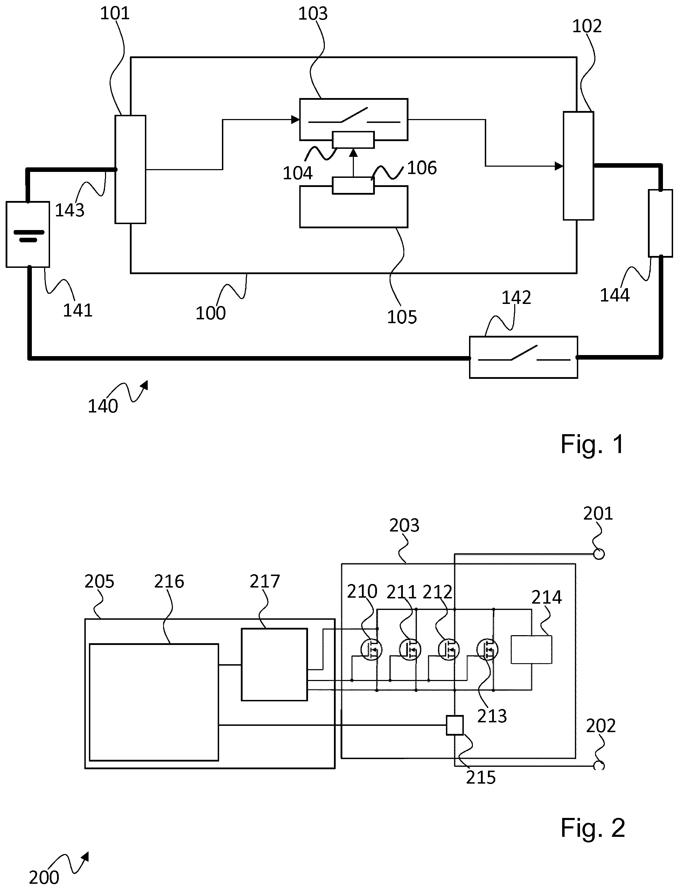

Figur 1 zeigt ein Blockschaltbild eines elektrischen Versorgungssystems 140. Das elektrische Versorgungssystem 140 weist eine Energiequelle 141 auf, deren positiver Ausgang über einen Lastpfad 143 mit dem Leistungseingang 101 einer Trennvorrichtung 100 gekoppelt ist. Ein Leistungsausgang 102 der Trennvorrichtung 100 ist mit einem positiven Anschluss einer Last 144 gekoppelt. Der negative Anschluss der Last 144 ist mit einem Schaltelement 142 gekoppelt, dessen zweiter Ausgang mit dem negativen Anschluss der Energiequelle gekoppelt ist. Die Last 144 kann Teil eines Zwischenkreises eines elektrischen Bordnetzes in einem Fahrzeug sein. In der Fig. 1 sind keine Induktivitäten dargestellt, die sowohl in den Leitungen zu der Last 144, als auch in der Last 144 selbst vorhanden sein können.

Die Trennvorrichtung 100 weist einen Leistungseingang 101 und einen Leistungsausgang 102 auf. Der Lastpfad 143 eines halbleiterbasierten Schaltelements 103 ist elektrisch zwischen dem Leistungseingang 101 und dem Leistungsausgang 102 angeordnet. Ferner ist eine Steuereinrichtung 105 vorgesehen. Ein Steuerausgang 106 der Steuereinrichtung 105 ist mit einem Steuereingang 104 des halbleiterbasierten Schaltelements 103 gekoppelt.

Beim Zuschalten der Last 144 kann zuerst das Schaltelement 142 im negativen Spannungszweig geschlossen werden. Bei diesem Schaltelement 142 kann es sich insbesondere um einen üblichen elektromechanischen Schütz oder ebenfalls um ein halbleiterbasiertes Schaltelement handeln.

Anschließend betreibt die Steuereinrichtung 105 das halbleiterbasierte Schaltelement 103 in einem Pulsbetrieb. Dazu schließt und öffnet die Steuereinrichtung 105 das halbleiterbasierte Schaltelement 103 bis zum Erreichen einer vorgegebenen Betriebsspannung an dem Leistungsausgang 102 zyklisch. Wird diese Spannung am Leistungsausgang 102 erreicht, wird das halbleiterbasierte Schaltelement 103 geschlossen. Es versteht sich, dass die zu erreichende Spannung am Leistungsausgang 102 die Ausgangsspannung der Energiequelle 141 sein kann. Diese Spannung am Leistungsausgang 102 kann direkt gemessen oder mittels impliziter Bestimmungsmethoden bestimmt werden, beispielsweise mittels einer Strommessung während des Pulsbetriebs. Steigt der gemessene Strom dabei nicht über einen vorgegebenen Wert an, kann daraus implizit geschlossen werden, dass die Spannung am Leistungsausgang 102 der Ausgangsspannung der Energiequelle 141 entspricht.

In der Trennvorrichtung 100 kann für die implizite Bestimmung mittels Strommessung ein Stromsensor verwendet werden. Dieser Stromsensor kann den Strom im Lastpfad 143 des halbleiterbasierten Schaltelements 103 erfassen. Die Steuereinrichtung 105 kann im Pulsbetrieb das halbleiterbasierte Schaltelement 103 entsprechend zyklisch basierend auf dem durch den Stromsensor gemessenen Strom öffnen und schließen.

Die Steuereinrichtung 105 öffnet das halbleiterbasierte Schaltelement 103, wenn der gemessene Strom einen vorgegebenen Maximalwert $I_{max}$ erreicht und das halbleiterbasierte Schaltelement 103 schließt, wenn der gemessene Strom einen vorgegebenen Minimalwert erreicht. Ferner kann die Steuereinrichtung 105 das halbleiterbasierte Schaltelement 103 schließen, wenn der gemessene Stromwert einen konstanten Wert unterhalb des vorgegebenen Maximalwerts $I_{max}$ einnimmt. Im hier diskutierten Sinne bedeutet "konstant", dass der Strom für einen vorgegebenen Zeitraum den vorgegebenen Maximalwert $I_{max}$ nicht erreicht.

Um die Funktion einer Sicherung abbilden zu können, kann die Steuereinrichtung 105 nach dem Beenden des Pulsbetriebs das halbleiterbasierte Schaltelement 103 öffnen, wenn der von dem Stromsensor gemessene Strom einen vorgegebenen Grenzwert überschreitet. Der Grenzwert entspricht dabei dem Auslösestrom der durch die Trennvorrichtung ersetzten Sicherung.

Figur 2 zeigt ein Blockschaltbild eines weiteren Ausführungsbeispiels einer Trennvorrichtung 200. Die Trennvorrichtung 200 weist ebenfalls einen Leistungseingang 201 und einen Leistungsausgang 202 auf, zwischen denen der Leistungspfad 143 (nicht in Fig. 2 dargestellt) des halbleiterbasierten Schaltelements 203 angeordnet ist. Ferner ist eine Steuereinrichtung 205 vorgesehen, welche das halbleiterbasierte Schaltelement 203 ansteuert. Das oben zu Figur 1 zu der Ansteuerung des halbleiterbasierten Schaltelements 203 durch die Steuereinrichtung 205 gesagte gilt hier analog.

Das halbleiterbasierte Schaltelement 203 weist eine Parallelschaltung aus vier MOSFETs 210, 211, 212, 213 auf. Die Drain-Anschlüsse der MOSFETs 210, 211, 212, 213 sind mit dem Leistungseingang 201 gekoppelt. Die Source-Anschlüsse der MOSFETs 210, 211, 212, 213 sind mit dem Leistungsausgang 202 gekoppelt. Ferner ist parallel zu den MOSFETs 210, 211, 212, 213 eine Schutzschaltung 214 vorgesehen. Diese dient dem Schutz der MOSFETs 210, 211, 212, 213 vor Spannungsspitzen oder dergleichen. In dem halbleiterbasierten Schaltelement 203 ist ferner ein Stromsensor 215 vorgesehen, der den Strom zwischen dem Leistungseingang 201 und dem Leistungsausgang 202 misst.

Die Steuereinrichtung 205 weist eine Steuereinheit 216 auf, die mit dem Stromsensor 215 und einer Treiberstufe 217 gekoppelt ist. Die Treiberstufe 217 dient der Erzeugung der Steuerspannung für die MOSFETs 210, 211, 212, 213, die gemäß Figur 1 in einer High-Side-Anordnung betrieben werden. Die Treiberstufe ist dazu mit den Drain-Anschlüssen, den Source-Anschlüssen und den Gate-Anschlüssen der MOSFETs 210, 211, 212, 213 gekoppelt. Auf die Details der Treiberstufe 217 wird hier nicht weiter eingegangen.

In dem halbleiterbasierten Schaltelement 203 können weitere Sensoren, wie Temperatursensoren oder dergleichen, eingesetzt werden, um wesentliche Parameter, wie die Temperatur, in dem halbleiterbasierten Schaltelement 203 zu überwachen. Ferner kann die Steuereinrichtung 205 weitere Schnittstellen zur Spannungsversorgung und zur Kommunikation, insbesondere in einem Fahrzeugbordnetz, aufweisen.

Zum leichteren Verständnis werden in der folgenden Beschreibung die Bezugszeichen zu den Figuren 1 und 2 als Referenz beibehalten.

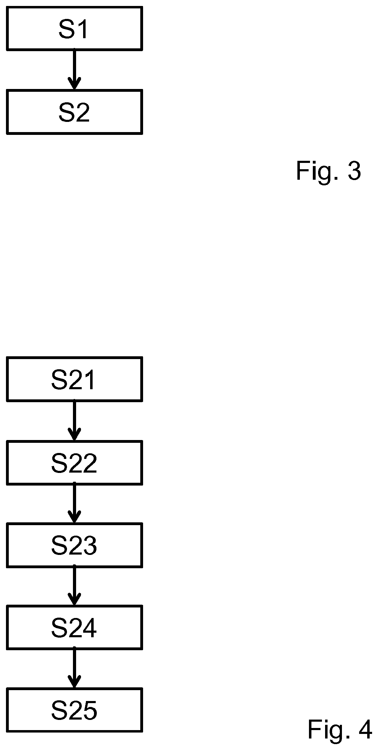

Figur 3 zeigt ein Ablaufdiagramm eines Verfahrens zum Betreiben einer Trennvorrichtung 100 für einen elektrischen Lastpfad 143 zur Versorgung elektrischer Lasten 144.

In einem ersten Schritt S1 des Öffnens und Schließens wird ein halbleiterbasiertes Schaltelement 103 dessen Lastpfad 143 elektrisch zwischen einem Leistungseingang 101, 201 und einem Leistungsausgang 102, 202 der Trennvorrichtung 100, 200 angeordnet ist, bis zum Erreichen einer vorgegebenen Betriebsspannung an dem Leistungsausgang 102, 202 in einem Pulsbetrieb geöffnet und geschlossen. In einem zweiten Schritt S2 des Schließens wird das halbleiterbasierte Schaltelement 103, 203 nach Erreichen einer vorgegebenen Betriebsspannung an dem Leistungsausgang 102, 202 geschlossen und der Pulsbetrieb beendet.

Im Pulsbetrieb kann das halbleiterbasierte Schaltelement 103, 203 zyklisch für einen ersten vorgegebenen Zeitraum geschlossen und für einen zweiten vorgegebenen Zeitraum geöffnet werden.

Zur Reduktion der Dauer des Einschaltvorgangs kann der Strom im Lastpfad 143 des halbleiterbasierten Schaltelements 103, 203 gemessen werden, wobei im Pulsbetrieb das halbleiterbasierte Schaltelement 103, 203 zyklisch basierend auf dem gemessenen Strom geöffnet und geschlossen werden kann. Dabei kann das halbleiterbasierte Schaltelement 103, 203 geöffnet werden, wenn der gemessene Strom einen vorgegebenen Maximalwert $I_{max}$ erreicht und das halbleiterbasierte Schaltelement 103, 203 kann geschlossen werden, wenn der gemessene Strom einen vorgegebenen Minimalwert erreicht.

Das halbleiterbasierte Schaltelement 103, 203 kann ferner geschlossen werden, wenn der gemessene Stromwert einen konstanten Wert unterhalb des vorgegebenen Maximalwerts $I_{max}$ einnimmt.

Nach dem Beenden des Pulsbetriebs kann das halbleiterbasierte Schaltelement 103, 203 als Sicherung genutzt und geöffnet werden, wenn der von dem Stromsensor 215 gemessene Strom einen vorgegebenen Maximalwerts $I_{max}$ überschreitet.

Figur 4 zeigt ein Ablaufdiagramm eines Ausführungsbeispiels eines Herstellverfahrens für eine Trennvorrichtung 100, 200 für einen elektrischen Lastpfad 143 zur Versorgung elektrischer Lasten 144.

In einem ersten Schritt S21 des Bereitstellens wird ein Leistungseingang 101, 201 bereitgestellt. In einem zweiten Schritt S22 des Bereitstellens wird ein Leistungsausgang 102, 202 bereitgestellt. In einem dritten Schritt S23 des Anordnens wird ein Lastpfad 143 eines halbleiterbasierten Schaltelements 103, 203 elektrisch zwischen dem Leistungseingang 101, 201 und dem Leistungsausgang 102, 202 angeordnet. In einem vierten Schritt S24 des Bereitstellens wird eine Steuereinrichtung 105, 205 bereitgestellt, welche ausgebildet ist, zum Schließen des halbleiterbasierten Schaltelements 103, 203 bis zum Erreichen einer vorgegebenen Betriebsspannung an dem Leistungsausgang 102, 202 das halbleiterbasierte Schaltelement 103, 203 in einem Pulsbetrieb zu schließen und zu öffnen. In einem fünften Schritt S25 des Verbindens wird ein Steuerausgang 106 der Steuereinrichtung 105, 205 mit einem Steuereingang 104 des halbleiterbasierten Schaltelements 103, 203 verbunden.

Das Herstellverfahren kann ferner das Anordnen eines Stromsensors 215 zwischen dem Leistungseingang 101, 201 und dem Leistungsausgang 102, 202 aufweisen, welcher ausgebildet ist, den Strom im Lastpfad 143 des halbleiterbasierten Schaltelements 103, 203 zu erfassen, und Koppeln des Stromsensors 215 mit der Steuereinrichtung 105, 205, wobei die Steuereinrichtung 105, 205 im Pulsbetrieb das halbleiterbasierte Schaltelement 103, 203 zyklisch basierend auf dem durch den Stromsensor 215 gemessenen Strom öffnet und schließt.

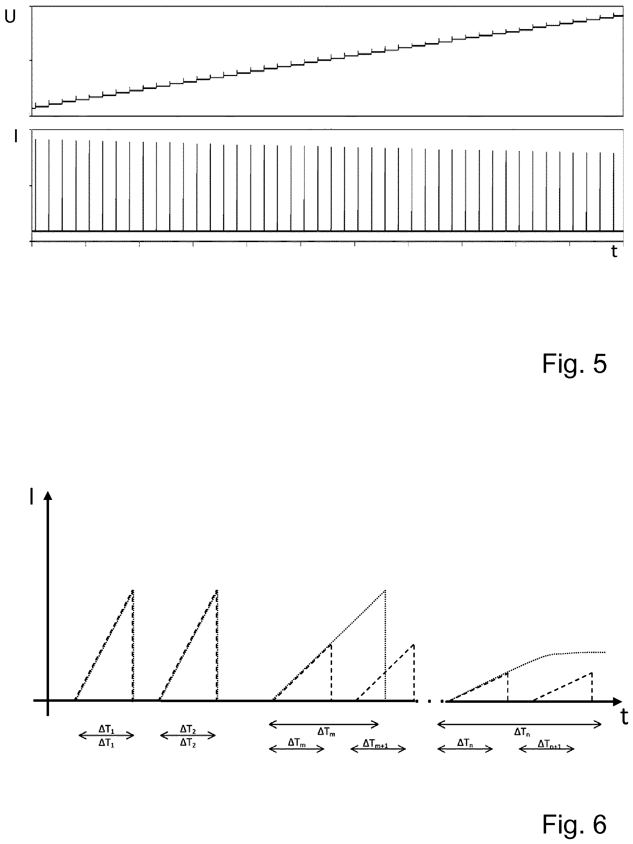

In den Diagrammen der Figuren 5 und 6 sind keine Spannungs- und Stromwerte angegeben, da diese je nach konkreter Ausgestaltung variieren und die Figuren 5 und 6 lediglich der Erläuterung des Wirkprinzips der vorliegenden Erfindung dienen.

Figur 5 zeigt ein Diagramm mit Spannungs- und Stromverlauf in einem Lastpfad 143 (nicht in der Figur 5 dargestellt) mit einer Ausführungsform einer Trennvorrichtung 100, 200 gemäß der vorliegenden Erfindung.

Es ist zu erkennen, das mit jedem Strompuls (untere Kurve) die Spannung (obere Kurve) in dem Zwischenkreis steigt. Die kurzen Spannungsspitzen, die beim Öffnen des halbleiterbasierten Schaltelements 103, 203 entstehen, werden durch die in den Induktivitäten des Zwischenkreises gespeicherte Energie erzeugt und klingen nach dem Öffnen des halbleiterbasierten Schaltelements 103, 203 ab. In dem unteren Diagramm ist ferner zu erkennen, dass der Betrag der Stromspitzen mit zunehmender Spannung in dem Zwischenkreis sinkt.

Figur 6 zeigt ein Diagramm mit Stromverläufen beim Pulsbetrieb einer Trennvorrichtung 100, 200. Die gestrichelte Linie stellt den Stromverlauf mit festen Pulslängen dar, während die gepunktete Linie den Stromverlauf mit variablen, also strombasierten Pulslängen darstellt.

Es ist zu erkennen, dass bei einem Betrieb mit festen Pulslängen von Puls zu Puls der maximal erreichte Strom geringer ist. Das bedeutet, dass mit jedem Puls in der gleichen Zeit weniger Energie in den Zwischenkreis übertragen wird.

Sind die Pulslängen dagegen variabel und werden dem Strom nachgeführt, verlängern sich die Pulse mit zunehmender Spannung in dem Zwischenkreis, da der Strom langsamer ansteigt. Wird ein Punkt erreicht, an welchem der Strom nicht bis zu dem erlaubten Maximalwert $I_{max}$ ansteigt und einen konstanten Wert annimmt, entspricht die Spannung im Zwischenkreis $U_{zk}$ der Ausgangsspannung $U_{bat}$ der Energiequelle 141.

Da es sich bei der vorhergehend detailliert beschriebenen Vorrichtungen und Verfahren um Ausführungsbeispiele handelt, können sie in üblicher Weise vom Fachmann in einem weiten Umfang modifiziert werden, ohne den Bereich der Erfindung zu verlassen. Insbesondere sind die mechanischen Anordnungen und die Größenverhältnisse der einzelnen Elemente zueinander lediglich beispielhaft.

BEZUGSZEICHENLISTE

| | |
|---|---|
| 100, 200 | Trennvorrichtung |
| 101, 201 | Leistungseingang |
| 102, 202 | Leistungsausgang |
| 103, 203 | halbleiterbasiertes Schaltelement |
| 104 | Steuereingang |
| 105, 205 | Steuereinrichtung |
| 106 | Steuerausgang |
| 140 | elektrisches Versorgungssystem |
| 141 | Energiequelle |
| 142 | Schaltelement |
| 143 | Lastpfad |
| 144 | Last |

| 210, 211, 212, 213 | MOSFET |
| --- | --- |
| 214 | Schutzschaltung |
| 215 | Stromsensor |
| 216 | Steuereinheit |
| 217 | Treiberstufe |

**Patentansprüche**

1. Trennvorrichtung (100, 200) für einen elektrischen Lastpfad (143) zur Versorgung elektrischer Lasten (144), aufweisend:

    einen Leistungseingang (101, 201),
    einen Leistungsausgang (102, 202),
    ein halbleiterbasiertes Schaltelement (103, 203), wobei der Lastpfad (143) des halbleiterbasierten Schaltelements (103, 203) elektrisch zwischen dem Leistungseingang (101, 201) und dem Leistungsausgang (102, 202) angeordnet ist, und
    eine Steuereinrichtung (105, 205), welche einen Steuerausgang (106) aufweist, der mit einem Steuereingang (104) des halbleiterbasierten Schaltelements (103, 203) gekoppelt ist, wobei die Steuereinrichtung (105, 205) ausgebildet ist, zum Schließen des halbleiterbasierten Schaltelements (103, 203) bis zum Erreichen einer vorgegebenen Betriebsspannung an dem Leistungsausgang (102, 202) das halbleiterbasierte Schaltelement (103, 203) in einem Pulsbetrieb zu schließen und zu öffnen.

2. Trennvorrichtung (100, 200) nach Anspruch 1, wobei die Steuereinrichtung (105, 205) ausgebildet ist, im Pulsbetrieb das halbleiterbasierte Schaltelement (103, 203) zyklisch für einen ersten vorgegebenen Zeitraum zu schließen und für einen zweiten vorgegebenen Zeitraum zu öffnen.

3. Trennvorrichtung (100, 200) nach Anspruch 1, aufweisend einen Stromsensor (215), welcher ausgebildet ist, den Strom im Lastpfad (143) des halbleiterbasierten Schaltelements (103, 203) zu erfassen, wobei die Steuereinrichtung (105, 205) ausgebildet ist, im Pulsbetrieb das halbleiterbasierte Schaltelement (103, 203) zyklisch basierend auf dem durch den Stromsensor (215) gemessenen Strom zu öffnen und zu schließen.

4. Trennvorrichtung (100, 200) nach Anspruch 3, wobei die Steuereinrichtung (105, 205) ausgebildet ist, das halbleiterbasierte Schaltelement (103, 203) zu öffnen, wenn der gemessene Strom einen vorgegebenen Maximalwert erreicht und das halbleiterbasierte Schaltelement (103, 203) zu schließen, wenn der gemessene Strom einen vorgegebenen Minimalwert erreicht, und/oder
wobei die Steuereinrichtung (105, 205) ausgebildet ist, das halbleiterbasierte Schaltelement (103, 203) zu schließen, wenn der gemessene Stromwert einen konstanten Wert unterhalb des vorgegebenen Maximalwerts einnimmt.

5. Trennvorrichtung (100, 200) nach einem der vorherigen Ansprüche 3 oder 4, wobei die Steuereinrichtung (105, 205) ausgebildet ist, nach dem Beenden des Pulsbetriebs das halbleiterbasierte Schaltelement (103, 203) zu öffnen, wenn der von dem Stromsensor (215) gemessene Strom einen vorgegebenen Grenzwert überschreitet.

6. Elektrisches Versorgungssystem (140) zur Versorgung elektrischer Lasten (144), aufweisend:

    eine Energiequelle (141),
    eine Trennvorrichtung (100, 200) nach einem der vorherigen Ansprüche, wobei der Leistungseingang (101, 201) der Trennvorrichtung (100, 200) mit einem positiven Ausgang der Energiequelle (141) gekoppelt ist, und
    wobei der Leistungsausgang (102, 202) der Trennvorrichtung (100, 200) mit einem positiven Eingang der elektrischen Lasten (144) gekoppelt ist.

7. Elektrisches Versorgungssystem (140) nach Anspruch 6, mit einem Schaltelement (142), welches elektrisch zwischen einem negativen Ausgang der elektrischen Lasten (144) und einem negativen Ausgang der Energiequelle (141) angeordnet ist.

8. Verfahren zum Betreiben einer Trennvorrichtung (100, 200) für einen elektrischen Lastpfad (143) zur Versorgung elektrischer Lasten (144), aufweisend die Schritte:

Öffnen und Schließen (S1) eines halbleiterbasierten Schaltelements (103, 203), dessen Lastpfad (143) elektrisch zwischen einem Leistungseingang (101, 201) und einem Leistungsausgang (102, 202) der Trennvorrichtung (100, 200) angeordnet ist, bis zum Erreichen einer vorgegebenen Betriebsspannung an dem Leistungsausgang (102, 202) in einem Pulsbetrieb, und

Schließen (S2) des halbleiterbasierten Schaltelements (103, 203) nach Erreichen der vorgegebenen Betriebsspannung.

9. Verfahren nach Anspruch 8, wobei im Pulsbetrieb das halbleiterbasierte Schaltelement (103, 203) zyklisch für einen ersten vorgegebenen Zeitraum geschlossen und für einen zweiten vorgegebenen Zeitraum geöffnet wird.

10. Verfahren nach Anspruch 9, aufweisend das Messen des Stroms im Lastpfad (143) des halbleiterbasierten Schaltelements (103, 203), wobei im Pulsbetrieb das halbleiterbasierte Schaltelement (103, 203) zyklisch basierend auf dem gemessenen Strom geöffnet und geschlossen wird.

11. Verfahren nach Anspruch 10, wobei das halbleiterbasierte Schaltelement (103, 203) geöffnet wird, wenn der gemessene Strom einen vorgegebenen Maximalwert erreicht und das halbleiterbasierte Schaltelement (103, 203) geschlossen wird, wenn der gemessene Strom einen vorgegebenen Minimalwert erreicht, und/oder wobei das halbleiterbasierte Schaltelement (103, 203) geschlossen wird, wenn der gemessene Stromwert einen konstanten Wert unterhalb des vorgegebenen Maximalwerts einnimmt.

12. Verfahren nach einem der vorherigen Ansprüche 10 oder 11, wobei nach dem Beenden des Pulsbetriebs das halbleiterbasierte Schaltelement (103, 203) geöffnet wird, wenn der von dem Stromsensor (215) gemessene Strom einen vorgegebenen Grenzwert überschreitet.

13. Herstellverfahren für eine Trennvorrichtung (100, 200) für einen elektrischen Lastpfad (143) zur Versorgung elektrischer Lasten (144), aufweisend die Schritte:

Bereitstellen (S21) eines Leistungseingangs (101, 201),
Bereitstellen (S22) eines Leistungsausgangs (102, 202),
Anordnen (S23) eines Lastpfads (143) eines halbleiterbasierten Schaltelements (103, 203) elektrisch zwischen dem Leistungseingang (101, 201) und dem Leistungsausgang (102, 202),
Bereitstellen (S24) einer Steuereinrichtung (105, 205), welche ausgebildet ist, zum Schließen des halbleiterbasierten Schaltelements (103, 203) bis zum Erreichen einer vorgegebenen Betriebsspannung an dem Leistungsausgang (102, 202) das halbleiterbasierte Schaltelement (103, 203) in einem Pulsbetrieb zu schließen und zu öffnen, und
Verbinden (S25) eines Steuerausgangs (106) der Steuereinrichtung (105, 205) mit einem Steuereingang (104) des halbleiterbasierten Schaltelements (103, 203).

14. Herstellverfahren nach Anspruch 13, aufweisend Anordnen eines Stromsensors (215) zwischen dem Leistungseingang (101, 201) und dem Leistungsausgang (102, 202), welcher ausgebildet ist, den Strom im Lastpfad (143) des halbleiterbasierten Schaltelements (103, 203) zu erfassen, und Koppeln des Stromsensors (215) mit der Steuereinrichtung (105, 205), wobei die Steuereinrichtung (105, 205) im Pulsbetrieb das halbleiterbasierte Schaltelement (103, 203) zyklisch basierend auf dem durch den Stromsensor (215) gemessenen Strom öffnet und schließt.

Fig. 1

Fig. 2

Fig. 3

Fig. 4

Fig. 5

Fig. 6

Europäisches Patentamt
European Patent Office
Office européen des brevets

## EUROPÄISCHER RECHERCHENBERICHT

Nummer der Anmeldung

EP 19 16 7525

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2012/235661 A1 (ROESSLER WERNER [DE] ET AL) 20. September 2012 (2012-09-20) * das ganze Dokument * ----- | 1-14 | INV. H03K17/082 H03K17/16 B60L15/08 H02H3/087 |
| X | EP 3 421 287 A1 (FICO TRIAD SA [ES]) 2. Januar 2019 (2019-01-02) * Abbildungen 5, 6 * ----- | 1,2,5-9, 12,13 | |

**RECHERCHIERTE SACHGEBIETE (IPC)**

H03K
H02H
H02J
B60L

Der vorliegende Recherchenbericht wurde für alle Patentansprüche erstellt

| Recherchenort | Abschlußdatum der Recherche | Prüfer |
|---|---|---|
| Den Haag | 1. Oktober 2019 | Loiseau, Ludovic |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 19 16 7525

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

01-10-2019

| Im Recherchenbericht angeführtes Patentdokument | Datum der Veröffentlichung | Mitglied(er) der Patentfamilie | Datum der Veröffentlichung |
|---|---|---|---|
| US 2012235661 A1 | 20-09-2012 | CN 102684140 A<br>DE 102012203995 A1<br>US 2012235661 A1 | 19-09-2012<br>20-09-2012<br>20-09-2012 |
| EP 3421287 A1 | 02-01-2019 | CN 109130893 A<br>EP 3421287 A1 | 04-01-2019<br>02-01-2019 |

EPO FORM P0461

Für nähere Einzelheiten zu diesem Anhang : siehe Amtsblatt des Europäischen Patentamts, Nr.12/82